# EUROPEAN PATENT APPLICATION

(11) **EP 1 545 171 A1**
(43) Date of publication of application: **22.06.2005**
(21) Application number: 03764152.9
(22) Date of filing: 09.07.2003
(51) Int. Cl.: H05K 3/06, H05K 3/40

(54) **METHOD OF FORMING PATTERN ON CERAMIC GREEN SHEET AND CONDUCTIVE PASTE FOR USE IN THE METHOD**

(30) Priority: 10.07.2002 JP 2002201337
(71) Applicant: TAIYO INK MFG. CO., LTD., Nerima-ku, Tokyo 176-8508 (JP)
(72) Inventor: OHNISHI, Shigekatsu, Taiyo InkMfg. Co., Ltd., Hiki-gun, Saitama 355-0222 (JP)
(74) Representative: Kramer Barske Schmidtchen
(86) International application number: PCT/JP2003/008729
(87) International publication number: WO 2004/008818

(57) **Abstract**

A method for forming a circuit pattern on a ceramic green sheet is provided having excellent productivity at a low-cost. The method is **characterized in that** alkaline soluble conductive paste (a), which contains binder soluble in alkaline aqueous solution and conductive particles as main ingredients, is filled in the via-holes of the ceramic green sheet without using a mask, and subsequently alkaline soluble photosensitive conductive paste (b) is further applied on the green sheet for a circuit pattern and is dried. Thereafter, the pattern is exposed to a light and is developed.

## Description

### TECHNICAL FIELD

The present invention relates to a method for forming a pattern on a ceramic green sheet. More particularly, the present invention relates to a method for forming a pattern, with which via-holes of the ceramic green sheet can be filled up with conductive paste without using a metal mask and to the conductive paste used for the method.

In the following description of the present invention, a ceramic green sheet means such a green sheet made of ceramics as used for producing a passive component or used suitably for sintered ceramic substrate for high-density mounting including especially a multilayer ceramic board.

### BACKGROUND OF THE INVENTION

Generally, a multilayer ceramic board is manufactured by a green sheet laminating method. According to the green sheet laminating method, a multilayer ceramic board is manufactured in the following process : punching via-holes at predetermined positions of two or more ceramic green sheets cut with a fixed size; filling up the via-holes of each ceramic green sheet with the conductive paste using a metal mask; printing a circuit pattern with conductive paste on a surface of each ceramic green sheet using a screen-stencil method ; laminating the ceramic green sheets and heating them under a pressure; and sintering the laminated ceramic green sheets.

Thus, the method using the metal mask having open holes is usually applied for selectively filling up the via-holes formed in the ceramic green sheet with the conductive paste.

However, this method has such drawbacks that it is necessary to use such a very expensive pattern mask as a metal mask and that it is necessary to align positions of the via-holes with a pattern mask, thereby making productivity low.

The present invention is made in order to remove such drawbacks. It is a main object of the present invention to provide a method for forming a pattern on a ceramic green sheet, which enables to realize high productivity at a low-cost by filling conductive paste into the via-holes of the ceramic green sheet without using a metal mask and to provide conductive paste using for the method.

### SUMMARY

Doing an extensive research in order to attain the above object, the present invention is finally made, which is composed of features shown below.

Namely, in a method for forming a pattern on a ceramic green sheet according to the present invention, alkaline soluble conductive paste (a) which contains alkaline soluble binder and conductive particles as main components is filled in via-holes in a ceramic green sheet without using a mask. Subsequently, alkaline soluble photosensitive conductive paste (b) is further applied on the green sheet filled with the conductive paste in the via-holes for forming a circuit pattern and is dried. Then, the circuit pattern is exposed and developed.

Further, alkaline soluble conductive paste used for the method is provided for filling the via-holes in the ceramic green sheet without using a mask, which contains at least binder soluble in alkali solution and conductive particles as main components.

Although the pattern printing can be carried out using a dried type or thermo setting type conductive paste instead of the paste (b), it is desirable to form the pattern by the exposure and development using the alkaline soluble photosensitive conductive paste (b) in order to obtain a very fine circuit pattern.

### BRIEF DESCRIPTION OF THE DRAWINGS

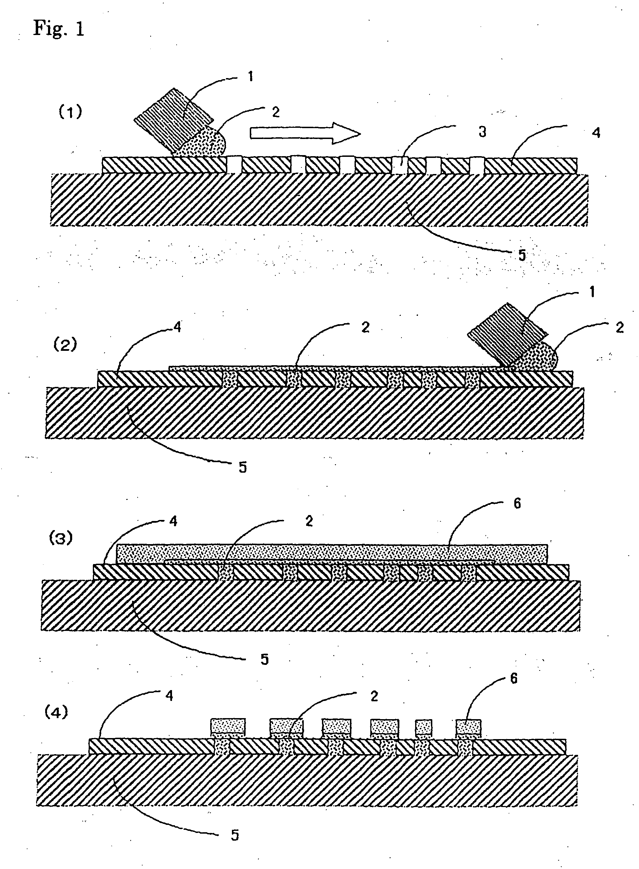

Fig. 1 is a diagram explaining a method for forming a pattern on a ceramic green sheet according to an embodiment of the invention, wherein (1) is a longitudinal sectional view of the ceramic green sheet for explaining via-holes filling process, (2) is a longitudinal sectional view of the ceramic green sheet for explaining a state of conductive paste filled into the via-holes, and (3) and (4) are longitudinal sectional view of the ceramic green sheet for explaining a process for forming a circuit pattern.

Here, numerals refer to parts as follows. 1: a squeegee, 2: alkaline soluble conductive paste, 3: a via-hole, 4: a ceramic green sheet, 5: a printing stand, and 6: alkaline soluble photosensitive conductive paste.

### DETAILED DESCRIPTION

A method for forming a pattern on a ceramic green sheet according to the present invention is different from a conventional pattern printing method for selectively filling up conductive paste in the via-holes in the ceramic green sheet.

That is, a method for forming a pattern on a ceramic green sheet according to an embodiment of the present invention is characterized in that (a) alkaline soluble conductive paste is filled in the via-holes of the ceramic green sheet by printing the paste on a whole surface of the sheet, and that (b) the alkaline soluble photosensitive conductive paste is applied on the ceramic green sheet for a circuit pattern and dried. Thereafter, it is exposed and developed.

Thus, since the alkaline soluble conductive paste (a) is adopted as conductive paste for filling the via-holes, unnecessary portions of a coated film of the alkaline soluble conductive paste (a) on the green sheet is removed in accordance with the pattern used for the exposure and development of alkaline soluble photosensitive conductive paste (b) in the development process for forming a circuit pattern.

Namely, the alkaline soluble conductive paste (a), which is printed on the green sheet at portions other than the via-holes are formed at the time when the via-holes are filled up, and which is not used for the circuit pattern is removed simultaneously in the development process.

Thus, according to the method of the present invention, filling of the conductive paste into the via-holes and forming of the circuit pattern can be carried out by a printing method without using a pattern mask. As a result, bleeding in the pattern printing is surely eliminated and printing quality is improved to satisfy a demand for very fine circuit patters. Furthermore, printing efficiency is improved without considering the alignment between the via-holes and the pattern mask, thereby highly improving the productivity.

Hereinafter, an embodiment of the method for forming a pattern on a ceramic green sheet according to the invention is explained with reference to Fig. 1.
(1) First, a ceramic green sheet 4 which has via-holes 3 is laid on a printing stand 5 and the via-holes 3 in the ceramic green sheet 4 is filled up with alkaline soluble conductive paste 2 for filling via-holes by printing, in which a squeegee 1 or the like is used.
   In this case, the via-holes are filled with the alkaline soluble conductive paste (a) by printing the paste to a whole surface of the sheet. Thus, the embodiment of the present invention is characterized in that the via-holes 3 are filled with the paste 2 by using the alkaline soluble conductive paste 2 without using a pattern mask. Therefore, the alkaline soluble conductive paste 2 is applied at a state of in a thin film on the ceramic green sheet at portions other than the via-holes in this process, as shown in Fig. 1 (1) and (2).
   Here, the ceramic green sheet 4 is formed from slurry of ceramic powder into a tape using the doctor blade method. The ceramic powder is not limited specific material but known ceramic dielectric materials, which are used for low-temperature sintering, can be applied.
(2) Next, a coating film formed in the step (1) is dried at about 60-120 degree C for about 5 to 40 minutes using a hot air circulation type drying oven or a far-infrared drying oven, if needed, for evaporating the organic solvent and a tack-free dried film is obtained.
(3) Then, the alkaline soluble photosensitive conductive paste 6 is further applied on the dried film formed on the ceramic green sheet 4, and is dried (see Fig.1(3)).
   Here, the alkaline soluble and photosensitive conductive paste 6 can be applied on the ceramic green sheet 4 by well-known methods, such as dip coating, screen printing, or a method using the squeegee, a dispenser or a roller. Then, the tack-free dried film is obtained by drying the paste at about 60-120 degree C for about 5 to 40 minutes using the air forced convection oven with circulating hot wind or the furnace with the far-infrared dryer.
(4) Next, pattern exposure is carried out by irradiating an active energy ray, such as an ultraviolet ray, to a whole or select portions on a surface of the dried film formed on the ceramic green sheet 4 with through a photo mask(see Fig. 1(3)).
   Contact exposure or non-contact exposure can be applied for the exposure process using a negative mask, which has a predetermined exposure pattern. A halogen lamp, a high-pressure mercury-vapor lamp, a laser beam, a metal halide lamp, a black lamp, an electrode less discharge lamp and the like can be used for an exposure light source. Exposure conditions are desirable in the range from 50 to 5000 mJ/cm2, although the conditions depend on a thickness of the coated film. Photo cure will be fully attained in this range.
(5) After exposure, unexposed portions of the film are developed with a developing solution (see Fig. 1 (4)).

The coated films are removed in the developing process, which are formed at portions on the ceramic green sheet 4 other than the via-holes and the circuit pattern.

In this developing process, a spray method, an immersing method and the like can be used. As a developing solution, alkaline aqueous solution such as sodium hydroxide, potassium hydroxide, sodium carbonate, potassium carbonate, sodium silicate and the like, or amine aqueous solution such as monoethanolamine, diethanolamine, triethanolamine and the like are applicable. Among them a diluted alkaline aqueous solution of a concentration below about 1.5 mass % is suitably used. The developing solution is not limited to the solutions described and thus any other developing solutions can be applied, with which a carboxyl group of contained in a resin forming paste can be saponified and a non-cured part (non-exposed part) can be removed. Washing with water or acid neutralization is performed to remove the unnecessary developing solution after the development.

The alkaline soluble conductive paste (a) and the alkaline soluble photosensitive conductive paste (b) are explained, which are used for the method for forming a pattern in the embodiment of the present invention.

The alkaline soluble conductive paste (a) contains alkaline soluble binder and conductive particles as main components. It is one of the features of the embodiment of the present invention that the alkaline soluble conductive paste is used for filling the via-holes. Coating films applied at unnecessary portions except for the portions of via-holes or of the circuit pattern are simultaneously removed in a development process for forming the circuit pattern and thus the via-holes can be filled up without using the metal mask.

Here, an aqueous alkaline soluble resin can be used as an alkaline soluble binder without any limitation. However, a composition containing at least a carboxyl group content resin is desirably used.

Specifically, carboxyl group content photosensitive resins having an ethylenically unsaturated double bond itself and a carboxyl group-containing resins having no ethylenically unsaturated double bond can be used.

For the conductive particles, particles, a simple substance such as Ag, Au, Pt, Pd, Ni, Cu, Al, Sn, Pb, Zn, Fe, Ir, Os, Rh, W, Mo or Ru and alloys thereof, an alloy, an oxide such as tin oxide (SnO2), indium oxide (In₂O₃), ITO (Indium Tin Oxide) or the like may be used. The conductive particles having such various kinds of shapes of spheres, flakes or dendrites may be used. However, it is especially desirable to use the conductive particles having the ball shape when high content of filler and flow ability of the paste are taken into consideration.

It is desirable that the content of such conductive particles contained in the alkaline soluble conductive paste (a) is 25 to 55 volume %, preferably 30 to 50 volume %. For example, when conductive particles consist of Ag powder, it is desirable that the content of the Ag powder is 75 to 92 mass % and preferably 80 to 91 mass %. When the content of the conductive particles is less than the above-mentioned range, the via-holes are apt to be filled insufficiently after sintering. On the other hand, it is not desirable that the content of the conductive particles is more than the above range, because the paste is not formed.

For the alkaline soluble photosensitive conductive paste (b), it is desirable to use a composite, which contains at least carboxyl group- containing resin, conductive particles, a photopolymerizable monomer, and a photo polymerization initiator.

Here, the carboxyl group content resin and the conductive particles are the same as those constituting the alkaline soluble conductive paste (a). Further, for the photo curable monomer or the photo polymerization initiator, well-known and commonly used photo curable monomer or the photo polymerization initiator may be used singly or in the form of a combination of two or more members.

It is preferable that the content of the conductive particles in the alkaline soluble photosensitive conductive paste (b) is 15 to 30 volume %, and preferably 15 to 25 volume %. When the content of the conductive particles is less than the above range, sufficient film thickness of the circuit pattern is not obtained after it is sintered. On the other hand, when the content of the conductive particles is more than the above range, it is not desirable because optical characteristic becomes worse.

The conductive paste used for the method according to the present invention may incorporate therin, as occasion demands, such other additives as a silicone- based or acrylic anti-foaming and leveling agents and a silane coupling agent for improving the adhesiveness of a coated film.

The present invention is explained in detail below using embodiments. However, it is not necessary to say that the present invention is not limited to the embodiments. In the following description, a word "part" means a mass part as long as it is not defined otherwise.

### (1) Production of the alkaline soluble conductive paste (a)

The alkaline soluble conductive paste (a) for filling the via-holes is produced by mixing the following components with the composition ratio shown below and kneaded with 3-rolls mill after being stirred with a mixer.
- conductive particles: 82%
   (Ag powder, which is mono sized spherical silver powder having an average particle size of 1 micrometer and a tap density of 5.1 g/cm³)
- binder soluble in alkaline aqueous solution: 10%
   (glycidyl methacrylate denaturation methacrylic acid - methacrylic acid methyl copolymer having an acid value of 110 mgKOH/g, and a number-average molecular weight of 5000)
- solvent (ethyl carbitol acetate): 8%

### (2) Production of the alkaline soluble photosensitive conductive paste (b)

The alkaline soluble photosensitive conductive paste (b) for forming a circuit pattern is produced by mixing the following constituents with the composition ratio shown below and milled by 3-rolls mill after being stirred with a mixer.
- conductive particles: 68.7%
   (Ag powder having a ball shape with simple distribution, a mean particle size of 1 micrometer and a tap density of 5.1 g/cm³)
- methacrylic acid - methacrylic acid methyl copolymer: 12.5% (having an acid value of 130 mgKOH/g and a number-average molecular weight of 36000)
- solvent (ethyl carbitol acetate): 12.5%
- trimethylolpropane trimethacrylate: 2.5%
- dipentaerythritol hexacrylate: 2.5%
- 2-methyl-1-[4-(methylthio)phenyl]-2- morpholino aminopropanone-12-methyl: 1.2%
- 2,4-diethyl thioxanthone: 0.1%

### (3) Filling the via-holes with the alkaline soluble conductive paste (a)

The via-holes in the ceramic green sheet, which are formed by punching, are filled with the alkaline soluble conductive paste (a) thus produced in the process (1) by printing using a rubber squeegee. In this process, no mask aligned with the via-hole pattern is necessary and a thin film conductive paste (a) is applied on a whole surface of the ceramic green sheet.

### (4) Printing of the alkaline soluble photosensitive conductive paste (b)

The alkaline soluble photosensitive conductive paste (b) thus produced in the process (2) is applied on the whole surface of the ceramic green sheet finished in the process (3), using the polyester screen of 250 meshes and is dried for 20 minutes at 80 degree C, and thus a coated film is formed having a thickness of about 20 micrometer and good tack-free touch.

### (5) Exposure

Pattern exposure of the dried coated film formed in the above process (4) is carried out, using a chromium mask, in which a fine pattern is formed and using a super-high-pressure mercury lamp as a light source, so that the accumulated amount of light on the coated film might be 200 mJ/cm².

### (6) Development

Dried coated film exposed in the above process (5) is developed using an aqueous 1 wt% Na₂CO₃ solution of 30 degree C and is washed by water.

In this process, due to the characteristic of the alkali solubility, the conductive paste (a), which is applied to the unnecessary portions other than the via-holes and the circuit pattern, is completely removed without any residue together with the photosensitive conductive paste (b) in accordance with the exposure pattern used in the above process (5).

Thus, with the method for forming a pattern according to the embodiment of the present invention, the via-holes in the ceramic green sheet can be completely filled up with conductive paste, without using a mask. Moreover, the conductive paste for filling the via-holes aplying to the unnecessary portions other than the via-holes and the circuit pattern can also be completely removed in the development process. Therefore, it has confirmed that a very fine circuit pattern was obtained.

### INDUSTRIAL APPLICABILITY

As explained above, according to the method of the present invention, the via-holes in the ceramic green sheet can be completely filled up with conductive paste and circuit pattern is formed on ceramic green sheet, without using a mask. Bleeding in the pattern printing is completely prevented and printing quality is improved to meet the needs of fine line conductors. Furthermore, printing efficiency is improved without considering the alignment between the positions of the via-holes and the pattern mask, thereby drastically improving the productivity.

## Claims

1. A method for forming a pattern on a ceramic green sheet comprising steps of:
filling via-holes formed in a ceramic green sheet with alkaline soluble conductive paste (a) which contains binder soluble in alkaline aqueous solution and conductive particles as main components without using a mask;
applying alkaline soluble photosensitive conductive paste (b) on the green sheet for a circuit pattern;
drying the alkaline soluble photosensitive conductive paste (b) applied on the green sheet;
exposing the dried alkaline soluble photosensitive conductive paste (b) applied on the green sheet for forming the circuit pattern to a light;
developing unexposed areas of the alkaline soluble photosensitive conductive paste (b) exposed for forming the circuit pattern.

2. A method for forming a pattern on a ceramic green sheet comprising at least the steps of:
(1) filling via-holes and forming a coated film for a circuit pattern by applying alkaline soluble conductive paste (a), which contains binder soluble in alkaline aqueous solution and conductive particles as main components on a ceramic green sheet having the via-holes without using a mask;
(2) applying alkaline soluble photosensitive conductive paste (b) for the circuit pattern on the ceramic green sheet, drying, thereafter exposing to a light and developing the pastes (a) and (b) for forming the circuit pattern.

3. A method for forming a pattern on a ceramic green sheet according to claim 1 or 2, wherein the composition ratio of the conductive particles in the alkaline soluble conductive paste (a) is 25 to 55 volume %.

4. A method for forming a pattern on a ceramic green sheet according to either one of the claim 1 - 3, wherein the composition ratio of the conductive particles in the alkaline soluble photosensitive conductive paste (b) is 15 to 30 volume %.

5. A method for forming a pattern on a ceramic green sheet according to claim 1 - 4, wherein the conductive particles consist of Ag powder.

6. Alkaline soluble conductive paste for filling via-holes formed in a ceramic green sheet without using a mask, comprising at least binder soluble in alkaline aqueous solution and conductive particles as main components.

7. Alkaline soluble conductive paste, which is used in a method for forming a pattern on a ceramic green sheet having via-holes without using a mask comprising the steps of: applying alkaline soluble conductive paste (a) for filling via-holes, and applying alkaline soluble photosensitive conductive paste (b) for forming a coated film for forming a pattern, drying, thereafter exposing to a light and developing the paste (a) and (b) for forming the circuit pattern.
wherein the alkaline soluble conductive paste (a) contains binder soluble in alkaline solution and conductive particles as main components.

8. Alkaline soluble conductive paste according to claim 6 or 7, wherein a composition ratio of the conductive particles in the alkaline soluble conductive paste is 25 to 55 volume %.

9. Alkaline soluble conductive paste according to either one of claims 6 - 8, wherein the conductive particles consist of Ag powder.

10. A ceramic green sheet having via-holes produced by the method for forming a circuit pattern on a ceramic green sheet according to either one of the claims 1 - 5, wherein the conductive paste is used for filling the via-holes and for forming the circuit pattern.

11. A ceramic green sheet having via-holes produced by using the conductive paste according to either one of the claims 6 - 9, wherein the conductive paste is used for filling the via-holes and for forming the circuit pattern.
